# EUROPEAN PATENT SPECIFICATION

(11) **EP 1 913 692 B1**
(45) Date of publication and mention of the grant of the patent: **28.04.2010**
(21) Application number: 06780213.2
(22) Date of filing: 26.07.2006
(51) Int. Cl.: H03H 17/02

(54) **DIGITAL FILTER**
DIGITALFILTER
FILTRE NUMERIQUE

(30) Priority: 29.07.2005 EP 05107017
(43) Date of publication of application: 23.04.2008
(73) Proprietor: NXP B.V., 5656 AG Eindhoven (NL)
(72) Inventor: FIFIELD, Robert, c/o Philips Intellectual Property & Standards, Redhill, Surrey RH1 5HA (GB)
(74) Representative: Gray, Peter John Bracey
(86) International application number: PCT/IB2006/052562
(87) International publication number: WO 2007/013036

(56) References cited:
- US-A- 5 048 088
- US-A1- 2001 050 966
- NEAU C ET AL: "Low complexity FIR filters using factorization of perturbed coefficients" DESIGN, AUTOMATION AND TEST IN EUROPE. CONFERENCE AND EXHIBITION 13-16 MARCH 2001, 13 March 2001 (2001-03-13), pages 268-272, XP010538203 ISBN: 0-7695-0993-2
- RICHARD I HARTLEY: "Subexpression Sharing in Filters Using Canonic Signed Digit Multipliers" IEEE TRANSACTIONS ON CIRCUITS AND SYSTEMS II: ANALOG AND DIGITAL SIGNAL PROCESSING, vol. 43, no. 10, October 1996 (1996-10), XP011012583 ISSN: 1057-7130
- CARREIRA A ET AL: "The multiplier tree FIR filter architecture" IEEE INTERNATIONAL CONFERENCE ON FIELD-PROGRAMMABLE TECHNOLOGY, 15-17 DEC. 2003, 15 December 2003 (2003-12-15), pages 447-450, XP010688386 ISBN: 0-7803-8320-6

## Description

This invention relates to a Finite Impulse Response (FIR) filter and a method of FIR filtering.

Digital filters are ubiquitous in digital circuits and digital signal processing. They are used to attenuate components of a signal in selected frequency ranges, which can help to reduce noise and interference. Finite Impulse Response (FIR) filters are a particular type of digital filter. Indeed, they are one of two main types of digital filter, the other main type being Infinite Impulse Response (IIR) filters. Their name is descriptive of their property that when a signal impulse is input to a FIR filter, the output will be finite, i.e. of limited length, which is a result of FIR filters not using any feedback. FIR filters are suited to a large number of applications. In particular, they are computationally efficient for so-called multi-rate applications, e.g. when a signal is interpolated or decimated to increase or decrease its sampling rate, as the finite nature of their output allows calculations not contributing to a decimated output, or calculations having predictable values in an interpolated output, to be omitted.

Tietze U and Schenk C, "Halbleiter-Schaltungstechnik", 1990, Berlin, Springer-\/erlag, Berlin, pages 803 to 807 describes basic structures of digital filters.

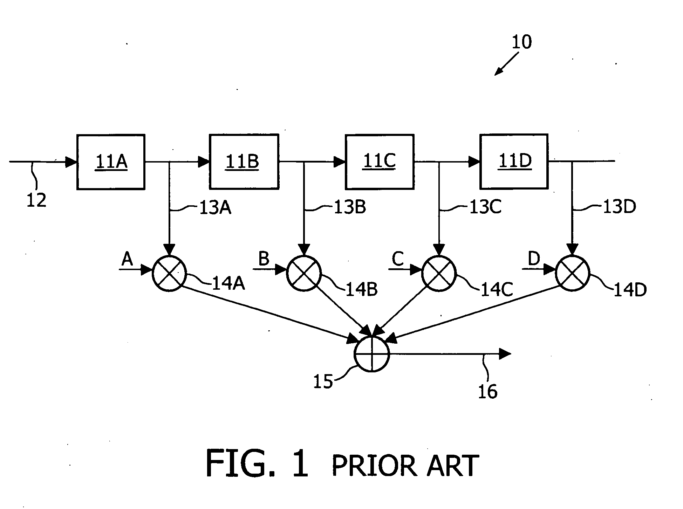

An example of a FIR filter of the prior art is shown in Figure 1. This FIR filter 10 has a delay line comprising four delay elements 11A, 11B, 11C, 11D connected in series to a filter input 12 for inputting a signal to the fitter 10. More specifically, the filter input 12 is connected to an input to a first delay element 11A, an output from the first delay element 11A is connected to an input to a second delay element 11B; an output from the second delay element 11B is connected to an input to a third delay element 11C; and an output from the third delay element 11C is connected to an input to a fourth delay element 11D. The filter 10 also has four taps 13A, 13B, 13C, 13D for extracting the signal from the delay line at points when it has different delays. Each of the taps 13A, 13B, 13C, 13D is connected to a point in the delay line at which the signal has a different delay. More specifically, a first tap 13A is connected to the output from the first delay element 11 A; a second tap 13B is connected to the output from the second delay element 11B; a third tap 13C is connected to the output from the third delay element 11C; and a fourth tap 13D is connected to an output from the fourth delay element 11 D. Each tap 13A, 13B, 13C, 13D has a multiplier 14A, 14B, 14C, 14D for multiplying the signals extracted from the delay line by a filter coefficient A, B, C, D. The filter coefficients A, B, C, D are selected according to the desired properties of the FIR filter 10, e.g. high pass, low pass or band pass and the precise frequency range of the stop band. The multipliers 14A, 14B, 14C, 14D are arranged in the taps 13A, 13B, 13C, 13D after the points at which the taps 13A, 13B, 13C, 13D extract the signal from the delay line. This means that the signal passes along the delay line unaffected by the multipliers 14A, 14B, 14C, 14D. The FIR filter 10 also has an adder 15 connected to outputs from each of the taps 13A, 13B, 13C, 13D (subsequent to the multipliers 14A, 14B, 14C, 14D) for adding the outputs from the taps 13A, 13B, 13C, 13D to generate a filter output 16.

In operation, a signal is input to the FIR filter 10 via the filter input 12. The first delay element 11A receives the signal from the input 12, delays it by a first given delay, which is typically one clock cycle, and outputs it to a second delay element 11B. The first tap 13A extracts the delayed signal from the delay line between the first delay element 11A and the second delay element 11 B. The multiplier 14A of the first tap 13A multiplies the extracted, delayed signal by the first filter coefficient A and the first tap 13A outputs the extracted, delayed, multiplied signal to the adder 15. The second delay element 11 B receives the delayed, unmultiplied signal from the first delay element 11A, delays it by a second given delay, again typically one clock cycle, and outputs the twice delayed signal to a third delay element 11C. The second tap 13B extracts the twice delayed signal from the delay line between the second delay element 11 B and the third delay element 11C. The multiplier 14B of the second tap 13B multiplies the extracted, twice delayed signal by the second filter coefficient B and the second tap 13B outputs the extracted, twice delayed, multiplied signal to the adder 15. The third delay element 11C receives the twice delayed, unmultiplied signal from the second delay element 11B, delays it by a third given delay, again typically one clock cycle, and outputs the three times delayed signal to a fourth delay element 11 D. The third tap 13C extracts the three times delayed signal from the delay line between the third delay element 11C and the fourth delay element 11D. The multiplier 14C of the third tap 13C multiplies the extracted, three times delayed signal by the third filter coefficient C and the third tap 13C outputs the extracted, three times delayed, multiplied signal to the adder 15. The fourth delay element 11 D receives the three times delayed, unmultiplied signal from the third delay element 11C, delays it by a fourth given delay, again typically one clock cycle, and outputs the four times delayed signal along the delay line. The fourth tap 13D extracts the four times delayed signal from the delay line after it is output from the fourth delay element 11 D. The multiplier 14D of the fourth tap 13D multiplies the extracted, four times delayed signal by the fourth filter coefficient D and the fourth tap 13D outputs the extracted, four times delayed, multiplied signal to the adder 15. The adder 15 receives the variously extracted, delayed and multiplied signals from the taps 13A, 13B, 13C, 13D and adds them together to generate the filter output 16.

This FIR filter 10 operates adequately. However, many desirable sets of filter coefficients A, B, C, D are relatively large and the multipliers 14A, 14B, 14C. 14D use many operations to perform the required multiplications. This means that, when the FIR filter 10 is implemented in hardware, e.g. in an Integrated Circuit (IC), the multipliers 14A 14B, 14C, 14D can be slow relative to say the adder 15 and can contribute significantly to the power consumption of the FIR filter 10. Similarly, when the FIR filter 10 is implemented in software, e.g. code processed by a Digital Signal Processor (DSP), the multipliers 14A 14B, 14C, 14D can contribute significantly to the number of processing steps required by the FIR filter 10. Schemes have therefore been developed to reduce the complexity of the multiplication required to be performed by FIR filters.

For example, the signal may be multiplied by another coefficient at the filter input 12. This effectively scales the signal extracted by each of the taps 13A, 13B, 13C, 13D and can reduce the complexity of the multiplication that needs to be performed by the multipliers 14A, 14B. 14C, 14D. However, this is effective for only certain combinations of filter coefficients A, B, C, D, for example when the filter coefficients A, B, C, D have one simple common mathematical factor that can be used as a scaling coefficient. If the filter coefficients A, B, C, D are unsuitable, this scheme can increase the overall complexity of the multiplication performed by the FIR filter 10. It is therefore desirable to find other ways of reducing the complexity of multiplication performed by digital filters.

US 5,048,088 discloses an IIR digital filter comprising multipliers in a delay line and multipliers in the taps, and indicates that the multipliers in the delay line may be removed and the multiplier parameters in the taps adjusted accordingly.

US 2001/0050966 discloses an FIR digital filter comprising multipliers in a delay line and multipliers in the taps, and discloses an equivalent filter in which the multipliers in the delay line are removed and the multiplier coefficients in the taps adjusted accordingly.

Neau et al, in "Low Complexity FIR Filters Using Factorization of Perturbed Coefficients", Design, Automation and Test in Europe, Conference and Exhibition 13-16 March 2001, 13 March 2001, pages 268-272, discloses the factorisation of filter coefficients into prime factors 2, 3, 5, 7, 11, 13..., stating that common factors allow a reduced complexity filter implementation.

According to a first aspect of the present invention there is provided a Finite lmpuse Response (FIR) filter for filtering a signal with FIR filter coefficients selected according to the desired properties of the FIR filter, the FIR filter comprising a delay line having multiple delay elements for successively delaying the signal; taps for extracting the signal from the delay line at points when it has different delays; multipliers for multiplying the signal by respective partial filter coefficients; and an adder for adding outputs from the taps to generate a filter output, wherein at least one of the multipliers is arranged in the delay line between the points at which a respective pair of the taps extract the signal from the delay line, wherein all of the multipliers are arranged in the delay line before one or more of the points at which the taps extract the signal from the delay line and wherein the multipliers are arranged in relation to the taps such that the partial filter coefficients combine to provide the FIR filter coefficients.

Also, according to a second aspect of the present invention, there is provided a method of Finite Impulse Response (FIR) filtering for filtering a signal with FIR filter coefficients selected according to the desired properties of the FIR filtering, the method comprising successively delaying the signal along a delay line; extracting the signal in taps from the delay line at points when it has different delays; multiplying the signal by partial filter coefficients; and adding outputs from the taps to generate a filter output, wherein at least one of the multiplications is performed in the delay line between the points at which respective pair of the taps extract the signal from the delay line, wherein all of the multiplications are performed in the delay line before one or more of the points at which the taps extract the signal from the delay line and the multiplications are performed in relation to the taps such that the partial filter coefficients combine to provide the FIR filter coefficients.

So, all of the multipliers are arranged in the delay line. The partial filter coefficients of the multipliers in the delay line may therefore combine to implement equivalent conventional FIR filter coefficients. In other words, cumulative multiplication can be used. However, positioning a multiplier in the delay line between two taps means that the signal extracted from the delay line by the tap or taps preceding the multiplier in the delay line can remain unaffected by the multiplier in the delay line. This allows a large number of different sets of FIR filter coefficients to be implemented using the invention with reduced complexity. More generally, for many sets of FIR filter coefficients, the overall number of operations required to perform multiplication in the filter can be significantly reduced and the digital filter and method of FIR filtering of the invention can therefore be quicker and use less power than equivalent filters and methods of the prior art.

Arranging the multipliers in the delay line can increase the extent to which cumulative multiplication is used to implement the FIR filter coefficients and reduce complexity. Indeed, all of the multipliers are arranged in the delay line before one or more of the points at which the taps extract the signal from the delay line. In other words, all of the multiplications are performed in the delay line before one or more of the points at which the taps extract the signal from the delay line. This is particularly effective, as all but the last multiplier or multiplication in the delay line contributes to implementing more than one equivalent conventional FIR filter coefficient.

Other implementation details of the FIR filter and method of FIR filtering can be largely selected as desired. For example, conventional binary representation may be used, although it is preferred that the digital filter and method of digital filtering use canonic representation. Canonic or canonical (binary) representation, also known as Canonic Signed Digit (CSD) representation, uses a symbol for -1, as well as conventional symbols for 0 and 1 of binary representation. This can further reduce the number of operations required for multiplication.

The invention may be implemented in hardware or software. For example, the digital filter may comprise an integrated circuit (IC). Alternatively, the digital filter may comprise computer software for processing on suitable processing means, such as a Digital Signal Processor (DSP). Indeed, according to a further aspect of the present invention, there is provided computer software or computer program code adapted to carry out the method described above when processed by processing means. The computer software or computer program code can be carried by a computer readable medium. The medium may be a physical storage medium such as a Read Only Memory (ROM) chip. Alternatively, it may be a disk such as a Digital Versatile Disk (DVD-ROM) or Compact Disk (CD-ROM). It could also be a signal such as an electronic signal over wires, an optical signal or a radio signal such as to a satellite or the like. The invention also extends to a processor running the software or code, e.g. a computer configured to carry out the method described above.

Preferred embodiments of the invention will now be described, by way of example only, with reference to the accompanying drawings, in which:
Figure 1 is a schematic illustration of a Finite Impulse Response (FIR) filter of the prior art;
Figure 2 is a schematic illustration of a FIR filter according to a preferred embodiment of the invention.

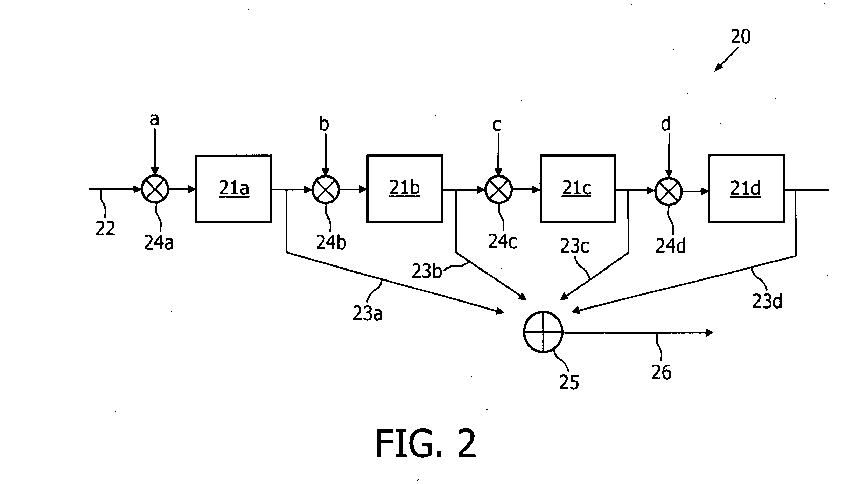

Referring to Figure 2, a Finite Impulse Response (FIR) filter 20 according to a first preferred embodiment of the invention has a delay line comprising four delay elements 21a, 21 b, 21 c, 21d connected in series to a filter input 22 for inputting a signal to the filter 20. The filter 20 also has four multipliers 24a, 24b, 24c, 24d arranged in the delay line. More specifically, the filter input 22 is connected to an input to a first multiplier 24a; an output from the first multiplier 24a is connected to an input to a first delay element 29a; an output from the first delay element 21a is connected to an input to a second multiplier 24b; an output from the second multiplier 24b is connected to an input to a second delay element 21 b; an output from the second delay element 21 b is connected to an input to a third multiplier 24c; an output from the third multiplier 24c is connected to an input to a third delay element 21 c; an output from the third delay element 21 c is connected to an input to a fourth multiplier 24d; and an output from the fourth multiplier 24d is connected to an input to a fourth delay element 21 d. The filter 20 also has four taps 23a, 23b, 23c, 23d for extracting the signal from the delay line at points when it has different delays. Each of the taps 23a, 23b, 23c, 23d is connected to a point in the delay line at which the signal has a different delay. More specifically, a first tap 23a is connected to the output from the first delay element 21 a; a second tap 23b is connected to the output from the second delay element 21b; a third tap 23c is connected to the output from the third delay element 21c; and a fourth tap 23d is connected to an output from the fourth delay element 21 d. An adder 25 is connected to outputs from the taps 23a, 23b, 23c, 23d for adding the outputs from the taps 23a, 23b, 23c, 23d to generate a filter output 26.

Each multiplier 24a, 24b, 24c, 24d is arranged to multiply the signal by a respective partial filter coefficient a, b, c, d. The multipliers 24a, 24b, 24c, 24d are arranged in relation to the taps 23a, 23b, 23c, 23d such that the partial filter coefficients a, b, c, d combine to provide equivalent conventional filter coefficients A, B, C, D for the respective taps 23a, 23b, 23c, 23d. These equivalent conventional filter coefficients A, B, C, D are selected according to the desired properties of the FIR filter 20, e.g. high pass, low pass or band pass and the precise frequency range of the stop band, in a conventional way. More specifically, as mentioned above, the multipliers 24a, 24b, 24c, 24d are all arranged in the delay line. The point at which the first tap 23a extracts the signal from the delay line is preceded in the delay line by only the first multiplier 24a (and the first delay element 21 a). The point at which the second tap 23b extracts the signal from the delay line is preceded in the delay line by only the first and second multipliers 24a, 24b (and the first and second delay elements 21 a, 21 b). The point at which the third tap 23c extracts the signal from the delay line is preceded in the delay line by only the first, second and third multipliers 24a, 24b, 24c (and the first, second and third delay elements 21a, 21b, 21c). Finally, the point at which the fourth tap 23d extracts the signal from the delay line is preceded in the delay line by all of the first, second, third and fourth multipliers 24a, 24b, 24c, 24d (and all of the first, second, third and fourth delay elements 21a, 21b, 21c, 21d). This means that the partial filter coefficients combine as follows to provide equivalent conventional filter coefficients A, B, C, D for the respective taps 23a, 23b, 23c, 23d: A = a, B = a*b, C = a*b*c, and D = a*b*c*d.

In operation, a signal is input to the filter 20 via the filter input 22. The first multiplier 24a multiplies the signal by the first partial filter coefficient a and outputs it to the first delay element 21a. The first delay element 21 a receives the multiplied signal from the first multiplier 24a, delays it by a first given delay, which is typically one clock cycle, and outputs it to the second multiplier 24b. The first tap 23a extracts the multiplied, delayed signal from the delay line between the first delay element 21 a and the second multiplier 24b and outputs it to the adder 25. The second multiplier 24b multiplies the delayed, multiplied signal by the second partial filter coefficient b and outputs it to the second delay element 21 b. The second delay element 21 b receives the delayed, twice multiplied signal from the second multiplier 24b, delays it by a second given delay, again typically one clock cycle, and outputs the it to the third multiplier 24c. The second tap 23b extracts the twice multiplied, twice delayed signal from the delay line between the second delay element 21 b and the third multiplier 24c and outputs it to the adder 25. The third multiplier 24c multiplies the twice multiplied, twice delayed signal by the third partial filter coefficient c and outputs it to the third delay element 21c. The third delay element 21c receives the three times multiplied, twice delayed signal from the third multiplier 24c, delays it by a third given delay, again typically one clock cycle, and outputs it to the fourth multiplier 23d. The third tap 23c extracts the three times multiplied, three times delayed signal from the delay line between the third delay element 21c and the fourth multiplier 24d and outputs it to the adder 25. The fourth multiplier 24d multiplies the three times multiplied, three times delayed signal by the fourth partial filter coefficient d and outputs it to the fourth delay element 21d. The fourth delay element 21d receives the four times multiplied, three times delayed signal from the fourth multiplier 24d, delays the signal by a fourth given delay, again typically one clock cycle, and outputs it along the delay line. The fourth tap 23d extracts the four times multiplied, four times delayed signal from the delay line after the fourth delay element 21 d and outputs it to the adder 25. The adder 25 receives the variously extracted, delayed and multiplied signals from the taps 23a, 23b, 23c, 23d and adds them together to generate filter output 26.

It is helpful to consider operation of the FIR filter 20 in comparison to operation of the FIR filter 10 of the prior art for particular filter coefficients A, B, C, D. In this example, the four filter coefficients A, B, C, D are selected to have values A = 7, B= -21, C = 189 and D = 945. Looking at the FIR filter 10 of the prior art first, in canonic representation (with -1 expressed as X), these filter coefficients A, B, C, D are expressed as, and require the following number of operations to be performed by the respective multipliers 14A, 14B, 14C, 14D

| | | |
|---|---|---|
| A = 7 | = 0000000100X | = 2 operations |
| B = -21 | = 0000X01011 | = 4 operations |
| C = 189 | = 00011000X01 | = 4 operations |
| D = 945 | = 100X0110001 | = 5 operations |

In other words, a total of 15 operations are required for multiplication in the FIR filter 10 of the prior art for the filter coefficients A = 7, B= -21, C = 189 and D = 945.

The number of operations can be significantly reduced by using the FIR filter 20 of the first preferred embodiment of the invention. Here, partial filter coefficients a = 7, b = -3, c = -9 and d = 5 combine to implement equivalent conventional filter coefficients A = 7, B= -21, C = 189 and D = 945. More specifically, A = a gives 7 = 7, B = a*b gives -21 = 7*-3, C = a*b*c gives 189 = 7*-3*-9, and D = a*b*c*d gives 945 = 7*-3*-9*5. Again using canonic representation, the partial filter coefficients a, b, c, d are expressed as, and require the following number of operations to be performed by the respective multipliers 24a, 24b, 24c, 24d

| | | |
|---|---|---|
| a = 7 | = 0100X | = 2 operations |
| b = -3 | = 00X01 | = 2 operations |
| c = -9 | = 1100X | = 3 operations |
| d = 5 | = 00101 | = 2 operations |

In other words, a total of 9 operations are required for multiplication in the FIR filter 20 of the first preferred embodiment of the invention for the equivalent conventional filter coefficients A = 7, B= -21, C = 189 and D = 945. This offers considerable savings in computational complexity and ultimately the FIR filter 20 of the first preferred embodiment of the invention is significantly quicker and uses less power than the FIR filter 10 of the prior art.

The described embodiments of the invention are only examples of how the invention may be implemented. Modifications, variations and changes to the described embodiments will occur to those having appropriate skills and knowledge. These modifications, variations and changes may be made without departure from the scope of the invention defined in the claims and its equivalents.

The inclusion of reference signs in parentheses in the claims is intended to aid understanding and is not intended to be limiting.

## Claims

1. A Finite lmpulse Response FIR filter (20) for filtering a signal with FIR filter coefficients (A,B,C,D) selected according to the desired properties of the filter (20) comprising a delay line having multiple delay elements (21a, 21 b, 21c, 21d) for successively delaying the signal; taps (23a, 23b, 23c, 23d) for extracting the signal from the delay line at points when it has different delays; multipliers (24a, 24b, 24c, 24d) for multiplying the signal by respective partial filter coefficients (a, b, c, d); and an adder (25) for adding outputs from the taps (23a, 23b, 23c, 23d) to generate a filter output (26), wherein at least one of the multipliers (24a, 24b, 24c, 24d) is arranged in the delay line between the points at which a respective pair of the taps (23a, 23b, 23c, 23d) extract the signal from the delay line, wherein all of the multipliers (24a, 24b, 24c, 24d) are arranged in the delay line before one or more of the points at which the taps (23a, 23b, 23c, 23d) extract the signal from the delay line, and wherein the multipliers (24a, 24b, 24c, 24d) are arranged in relation to the taps (23a, 23b, 23c, 23d) such that the partial filter coefficients (a, b, c, d) combine to provide the FIR filter coefficients (A, B, C, D).

2. The FIR fillter (20) of claim 1, using canonic representation.

3. A method of Finite lmpulse Response FIR filtering for filtering a signal with FIR filter coefficients (A, B, C, D) selected according to the desired properties of the FIR filtering, the method comprising successively delaying the signal along a delay line; extracting the signal in taps (23a, 23b, 23c, 23d) from the delay line at points when it has different delays; multiplying the signal by partial filter coefficients (a, b, c, d); and adding outputs from the taps (23a, 23b, 23c, 23d) to generate a filter output (26), wherein at least one of the multiplications is performed in the delay line between the points at which a respective pair of the taps (23a, 23b, 23c, 23d) extract the signal from the delay line, wherein all of the multiplications are performed in the delay line before one or more of the points at which the taps (23a, 23b, 23c, 23d) extract the signal from the delay line, and wherein the multiplications are performed in relation to the taps (23a, 23b, 23c, 23d) such that the partial filter coefficients (a, b, c, d) combine to provide the FIR filter coefficients (A, B, C, D).

4. The method of claim 3, using canonic representation.

5. Computer software adapted to carry out the method of claim 3 or claim 4, when processed by computer processing means.

## Patentansprüche

1. FIR-Filter (20) (finite impulse response - endliche Impulsantwort) zum Filtern eines Signals mit FIR-Filterkoeffizienten (A, B, C, D) ausgewählt entsprechend den gewünschten Eigenschaften des FIR-Filters (20) umfassend eine Verzögerungsleitung mit mehreren Verzögerungselementen (21a, 21b, 21c, 21d) zum aufeinanderfolgenden Verzögern des Signals; Abgriffe (23a, 23b, 23c, 23d) zum Extrahieren des Signals aus der Verzögerungsleitung an Punkten, wenn es unterschiedliche Verzögerungen aufweist; Multiplizierer (24a, 24b, 24c, 24d) zum Multiplizieren des Signals mit jeweiligen partiellen Filterkoeffizienten (a, b, c, d); und einen Addierer (25) zum Addieren von Ausgaben von den Abgriffen (23a, 23b, 23c, 23d) zum Generieren einer Filterausgabe (26), wobei mindestens einer der Multiplizierer (24a, 24b, 24c, 24d) in der Verzögerungsleitung zwischen den Punkten angeordnet ist, an denen ein jeweiliges Paar der Abgriffe (23a, 23b, 23c, 23d) das Signal aus der Verzögerungsleitung extrahiert, wobei alle Multiplizierer (24a, 24b, 24c, 24d) in der Verzögerungsleitung vor einem oder mehreren der Punkte angeordnet sind, an denen die Abgriffe (23a, 23b, 23c, 23d) das Signal aus der Verzögerungsleitung extrahieren, und wobei die Multiplizierer (24a, 24b, 24c, 24d) in Relation zu den Abgriffen (23a, 23b, 23c, 23d) derart angeordnet sind, dass die partiellen Filterkoeffizienten (a, b, c, d) zusammen die FIR-Filterkoeffizienten (A, B, C, D) liefern.

2. FIR-Filter (20) nach Anspruch 1 unter Verwendung einer kanonischen Repräsentation.

3. Verfahren zur FIR-Filterung zum Filtern eines Signals mit FIR-Filterkoeffizienten (A, B, C, D) ausgewählt entsprechend den gewünschten Eigenschaften der FIR-Filterung, wobei das Verfahren Folgendes umfasst: aufeinanderfolgendes Verzögern des Signals entlang einer Verzögerungsleitung; Extrahieren des Signals in Abgriffen (23a, 23b, 23c, 23d) aus der Verzögerungsleitung an Punkten, wenn es unterschiedliche Verzögerungen aufweist; Multiplizieren des Signals mit partiellen Filterkoeffizienten (a, b, c, d); und Addieren von Ausgaben von den Abgriffen (23a, 23b, 23c, 23d) zum Generieren einer Filterausgabe (26), wobei mindestens eine der Multiplikationen in der Verzögerungsleitung zwischen den Punkten durchgeführt wird, an denen ein jeweiliges Paar der Abgriffe (23a, 23b, 23c, 23d) das Signal aus der Verzögerungsleitung extrahiert, wobei alle Multiplikationen in der Verzögerungsleitung vor einem oder mehreren der Punkte durchgeführt werden, an denen die Abgriffe (23a, 23b, 23c, 23d) das Signal aus der Verzögerungsleitung extrahieren, und wobei Multiplikationen in Relation zu den Abgriffen (23a, 23b, 23c, 23d) derart ausgeführt werden, dass die partiellen Filterkoeffizienten (a, b, c, d) zusammen die FIR-Filterkoeffizienten (A, B, C, D) liefern.

4. Verfahren nach Anspruch 3 unter Verwendung einer kanonischen Repräsentation.

5. Computersoftware, die dafür ausgelegt ist, bei Verarbeitung durch Computerverarbeitungsmittel das Verfahren nach Anspruch 3 oder Anspruch 4 auszuführen.

## Revendications

1. Filtre (20) à Réponse Impulsionnelle Finie (FIR) pour filtrer un signal avec des coefficients de filtration FIR (A, B, C, D) sélectionnés suivant les propriétés souhaitées de ce filtre FIR (20), comprenant une ligne de retard ayant de multiples éléments de retard (21a, 21 b, 21 c, 21 d) pour retarder successivement le signal ; des prises (23a, 23b, 23c, 23d) pour extraire le signal de la ligne de retard en des points quand elle comporte des retards différents ; des multiplicateurs (24a, 24b, 24c, 24d) pour multiplier le signal par les coefficients partiels de filtration respectifs (a, b, c, d) ; et un additionneur (25) pour additionner les sorties des prises (23a, 23b, 23c, 23d) afin de générer une sortie de filtre (26), dans lequel au moins un des multiplicateurs (24a, 24b, 24c, 24d) est agencé dans la ligne de retard entre les points auxquels une paire respective des prises (23a, 23b, 23c, 23d) extrait le signal de la ligne de retard, dans lequel tous les multiplicateurs (24a, 24b, 24c, 24d) sont agencés dans la ligne de retard avant un ou plusieurs des points auxquels les prises (23a, 23b, 23c, 23d) extraient le signal de la ligne de retard et dans lequel les multiplicateurs (24a, 24b, 24c, 24d) sont agencés par rapport aux prises (23a, 23b, 23c, 23d) de manière que les coefficients partiels de filtration (a, b, c, d) se combinent pour fournir les coefficients de filtration FIR (A, B, C, D).

2. Filtre FIR (20) selon la revendication 1, utilisant une représentation canonique.

3. Procédé de filtration à Réponse Impulsionnelle Finie (FIR) pour filtrer un signal avec des coefficients de filtration FIR (A, B, C, D) sélectionnés suivant les propriétés souhaitées de la filtration FIR, le procédé comprenant un retardement successif du signal le long d'une ligne de retard ; une extraction du signal dans les prises (23a, 23b, 23c, 23d) de la ligne de retard en des points quand elle a des retards différents ; une multiplication du signal par des coefficients partiels de filtration (a, b, c, d) ; et l'addition des sorties venant des prises (23a, 23b, 23c, 23d) pour générer une sortie de filtre (26), dans lequel au moins une des multiplications est réalisée dans la ligne de retard entre les points auxquels une paire respective des prises (23a, 23b, 23c, 23d) extrait le signal de la ligne de retard, dans lequel toutes les multiplications sont réalisées dans la ligne de retard avant un ou plusieurs des points auxquels les prises (23a, 23b, 23c, 23d) extraient le signal de la ligne de retard, et dans lequel les multiplications sont réalisées par rapport aux prises (23a, 23b, 23c, 23d) de manière que les coefficients partiels de filtration (a, b, c, d) se combinent pour fournir les coefficients de filtration FIR (A, B, C, D).

4. Procédé selon la revendication 3, utilisant une représentation canonique.

5. Logiciel conçu pour réaliser le procédé de la revendication 3 ou de la revendication 4 quand il est traité par des moyens de traitement informatique.
